(19) Europäisches Patentamt
European Patent Office
Office européen des brevets

(11) **EP 4 646 078 A1**

(12) **EUROPEAN PATENT APPLICATION**
published in accordance with Art. 153(4) EPC

(43) Date of publication:
**05.11.2025 Bulletin 2025/45**

(21) Application number: **23957133.4**

(22) Date of filing: **31.10.2023**

(51) International Patent Classification (IPC):
*H10K 59/12* (2023.01)     *H10D 86/00* (2025.01)
*G09G 3/20* (2006.01)

(52) Cooperative Patent Classification (CPC):
**G09G 3/20; H10K 59/12**

(86) International application number:
**PCT/CN2023/128575**

(87) International publication number:
**WO 2025/091256 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **XIE, Taofeng
Beijing 100176 (CN)**
• **XU, Yuanjie
Beijing 100176 (CN)**
• **XIAO, Xingliang
Beijing 100176 (CN)**

(74) Representative: **Potter Clarkson
Chapel Quarter
Mount Street
Nottingham NG1 6HQ (GB)**

(54) **DISPLAY PANEL AND DISPLAY APPARATUS**

(57)     A display panel and a display apparatus. The display panel comprises a pixel driving circuit. The pixel driving circuit comprises a driving transistor (T3), a fifth transistor (T5) and an eighth transistor (T8). A first electrode of the fifth transistor (T5) is connected to a first power line (VDD), a second electrode of the fifth transistor (T5) is connected to a first electrode of the driving transistor (T3), and a second electrode of the eighth transistor (T8) is connected to the first electrode of the driving transistor (T3). The display panel comprises: a base substrate, an enable signal line (EM) and a third initial signal line (Vinit3). The enable signal line (EM) is located on a side of the base substrate, and the enable signal line (EM) is connected to a gate of the fifth transistor (T5), the orthographic projection of the enable signal line (EM) on the base substrate extending in a first direction (X). The third initial signal line (Vinit3) is located on a side of the base substrate, and the third initial signal line (Vinit3) is connected to a first electrode of an eighth transistor (T8). The third initial signal line (Vinit) comprises a first extension part (Vinit31), a second extension part (Vinit32) and a third extension part (Vinit33), the third extension part (Vinit33) being connected between the first extension part (Vinit31) and the second extension part (Vinit32). The orthographic projection of the first extension part (Vinit3 1) on the base substrate and the orthographic projection of the second extension part (Vinit32) on the base substrate extend in the first direction (X) and are offset with respect to each other in a second direction (Y), the first direction (X) and the second direction (Y) intersecting each other. The orthographic projection of the first extension part (Vinit31) on the base substrate does not intersect the orthographic projection of the enable signal line (EM) on the base substrate, and the orthographic projection of the second extension part (Vinit32) on the base substrate does not intersect the orthographic projection of the enable signal line (EM) on the base substrate. The display panel can improve display quality.

**(Cont. next page)**

EP 4 646 078 A1

FIG. 3

## Description

## TECHNICAL FIELD

This disclosure relates to the field of display technology and, more particularly, to a display panel and a display apparatus.

## BACKGROUND

In the related art, an enable signal line may output a plurality of pulse signals during a drive cycle of a pixel drive circuit to improve display quality of a display panel. However, the enable signal line may cause a coupling effect on other conductive layer structures, thereby resulting in unstable voltage on the other conductive structures, which may in turn lead to issues such as horizontal stripes or poor screen splitting in the display panel.

It should be noted that information disclosed in the Background is only used to acquire a better understanding of the background of this disclosure and therefore may include information that does not constitute the related art already known to those skilled in the art.

## SUMMARY

According to an aspect of this disclosure, there is provided a display panel, including a pixel drive circuit, the pixel drive circuit including a drive transistor, a fifth transistor, and an eighth transistor, a first electrode of the fifth transistor being connected to a first power line, a second electrode of the fifth transistor being connected to a first electrode of the drive transistor, and a second electrode of the eighth transistor being connected to the first electrode of the drive transistor;

the display panel including:
a base substrate;
an enable signal line on a side of the base substrate, the enable signal line being connected to a gate electrode of the fifth transistor, and an orthographic projection of the enable signal line on the base substrate extending along a first direction; and
a third initial signal line on the side of the base substrate, the third initial signal line being connected to a first electrode of the eighth transistor, the third initial signal line including a first extension part, a second extension part, and a third extension part, the third extension part being connected between the first extension part and the second extension part, wherein an orthographic projection of the first extension part on the base substrate and an orthographic projection of the second extension part on the base substrate extend along the first direction and are staggered in a second direction, the first direction intersecting with the second direction; the orthographic projection of the first extension part on the base substrate does not intersect with the orthographic projection of the enable signal line on the base substrate, and the orthographic projection of the second extension part on the base substrate does not intersect with the orthographic projection of the enable signal line on the base substrate.

In an exemplary embodiment of the present disclosure, the display panel further includes:

a first active layer on the side of the base substrate, the first active layer including a fifth active part, the fifth active part being configured to form a channel region of the fifth transistor; and
a first conductive layer on a side of the first active layer away from the base substrate, the first conductive layer including the enable signal line, the orthographic projection of the enable signal line on the base substrate covering an orthographic projection of the fifth active part on the base substrate, and a partial structure of the enable signal line being configured to form the gate electrode of the fifth transistor.

In an exemplary embodiment of the present disclosure, an orthographic projection of the third extension part on the base substrate intersects with the orthographic projection of the enable signal line on the base substrate.

In an exemplary embodiment of the present disclosure, the pixel drive circuit further includes a second transistor, a first electrode of the second transistor being connected to a gate electrode of the drive transistor, and a second electrode of the second transistor being connected to a second electrode of the drive transistor;

the display panel further includes a fourth conductive layer on the side of the base substrate, the fourth conductive layer including a first bridge part, the first bridge part being connected to the gate electrode of the drive transistor and the first electrode of the second transistor through via holes;
in the same pixel drive circuit, the orthographic projection of the first extension part on the base substrate is between the orthographic projection of the enable signal line on the base substrate and an orthographic projection of the first bridge part on the base substrate.

In an exemplary embodiment of the present disclosure, the display panel further includes:

a first active layer including an eighth active part, the eighth active part being configured to form a channel region of the eighth transistor; and
a first conductive layer including a second reset signal line, an orthographic projection of the second reset signal line on the base substrate extending along the first direction and covering an orthographic projection of the eighth active part on the base substrate, and a partial structure of the second reset signal line being configured to form a gate electrode of the eighth transistor, wherein in the same pixel drive circuit, at least a part of the orthographic projection of the second extension part on the base substrate is on a side of the orthographic projection of the second reset signal line on the base substrate away from the orthographic projection of the enable signal line on the base substrate.

In an exemplary embodiment of the present disclosure, the display panel further includes a light-emitting unit, the pixel drive circuit is configured to drive the light-emitting unit to emit light, the pixel drive circuit further includes a sixth transistor, a first electrode of the sixth transistor is connected to a second electrode of the drive transistor, and a second electrode of the sixth transistor is connected to a first electrode of the light-emitting unit;

the display panel further includes a first active layer including a sixth active part and an eighth active part, the sixth active part being configured to form a channel region of the sixth transistor, and the eighth active part being configured to form a channel region of the eighth transistor; in the same pixel drive circuit, in the first direction, at least a part of the orthographic projection of the third extension part on the base substrate is between an orthographic projection of the sixth active part on the base substrate and an orthographic projection of the eighth active part on the base substrate.

In an exemplary embodiment of the present disclosure, an orthographic projection of the first power line on the base substrate and the orthographic projection of the third extension part on the base substrate extend along the second direction, and the orthographic projection of the first power line on the base substrate does not overlap with the orthographic projection of the third extension part on the base substrate.

In an exemplary embodiment of the present disclosure, the display panel further includes:

a first active layer including a third active part, the third active part being configured to form a channel region of the drive transistor; and a first conductive layer including a first conductive part, an orthographic projection of the first conductive part on the base substrate covering an orthographic projection of the third active part on the base substrate, and the first conductive part being configured to form a gate electrode of the drive transistor, wherein in the same pixel drive circuit, an orthographic projection of the third initial signal line on the base substrate is on a side of the orthographic projection of the enable signal line on the base substrate away from the orthographic projection of the first conductive part on the base substrate.

In an exemplary embodiment of the present disclosure, the first active layer further includes an eighth active part configured to form a channel region of the eighth transistor;

the first conductive layer further includes a second reset signal line, an orthographic projection of the second reset signal line on the base substrate extending along the first direction and covering an orthographic projection of the eighth active part on the base substrate, and a partial structure of the second reset signal line being configured to form a gate electrode of the eighth transistor; the orthographic projection of the first extension part on the base substrate at least partially overlaps with the orthographic projection of the second reset signal line on the base substrate in a same row of the pixel drive circuit.

In an exemplary embodiment of the present disclosure, the display panel further includes a light-emitting unit, and the pixel drive circuit is configured to drive the light-emitting unit to emit light;

the pixel drive circuit further includes a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit; the display panel further includes: a first active layer on the side of the base substrate, the first active layer including a first active part, a third active part, and a seventh active part, the first active part being configured to form a channel region of the first transistor, the third active part being configured to form a channel region of the drive transistor, and the seventh active part being configured to form a channel region of the seventh transistor; and a first conductive layer on a side of the first active layer away from the base substrate, the first conductive layer including a first reset signal line, a second reset signal line, and a first conductive part, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor, an orthographic projection of the first conductive part on the base substrate covering an orthographic projection of the third active part on the base substrate, and the first conductive part being configured to form a gate electrode of the drive transistor; the orthographic projection of the second extension part on the base substrate is between the orthographic projection of the first reset signal line on the base substrate in an adjacent next row of the pixel drive circuit and the orthographic projection of the second reset signal line on the base substrate in a same row of the pixel drive circuit.

In an exemplary embodiment of the present disclosure, the pixel drive circuit further includes a second transistor, a first electrode of the second transistor being connected to a gate electrode of the drive transistor;

the display panel further includes a fourth conductive layer on the side of the base substrate, the fourth conductive layer including a first bridge part, the first bridge part being connected to the gate electrode of the drive transistor and the first electrode of the second transistor through via holes, wherein the fourth conductive layer further includes the third initial signal line.

In an exemplary embodiment of the present disclosure, the display panel further includes a light-emitting unit, and the pixel drive circuit is configured to drive the light-emitting unit to emit light;

the pixel drive circuit further includes a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit; the display panel further includes: a first active layer on the side of the base substrate, the first active layer including a first active part, a third active part, and a seventh active part, the first active part being configured to form a channel region of the first transistor, the third active part being configured to form a channel region of the drive transistor, and the seventh active part being configured to form a channel region of the seventh transistor; and a first conductive layer on a side of the first active layer away from the base substrate, the first conductive layer including a first reset signal line, a second reset signal line, and a first conductive part, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor, an orthographic projection of the first conductive part on the base substrate covering an orthographic projection of the third active part on the base substrate, and the first conductive part being configured to form a gate electrode of the drive transistor; in the same pixel drive circuit, the orthographic projection of the first conductive part on the base substrate is between the orthographic projection of the first reset signal line on the base substrate and the orthographic projection of the second reset signal line on the base substrate; an orthographic projection of the third initial signal line on the base substrate is at least partially located between the orthographic projection of the second reset signal line on the base substrate in a same row of the pixel drive circuit and the orthographic projection of the first reset signal line on the base substrate in an adjacent next row of the pixel drive circuit.

In an exemplary embodiment of the present disclosure, the display panel further includes:

a fifth conductive layer on a side of the first conductive layer away from the base substrate, the fifth conductive layer including a ninth bridge part, and the ninth bridge part being connected to the first electrode of the fifth transistor through a via hole; a sixth conductive layer on a side of the fifth conductive layer away from the fifth conductive layer, the sixth conductive layer including the first power line, and the first power line being connected to the ninth bridge part through a via hole; and a seventh conductive layer on a side of the sixth conductive layer away from the base substrate, the seventh conductive layer including the third initial signal line.

In an exemplary embodiment of the present disclosure, the fifth conductive layer includes a plurality of ninth bridge parts and a plurality of first connection parts, the plurality of ninth bridge parts being distributed in the first direction and the second direction, and the first connection parts being connected between two adjacent ninth bridge parts in the first direction;

the sixth conductive layer includes a plurality of first power lines, orthographic projections of the plurality of first power lines on the base substrate extending along the second direction and being spaced apart along the first direction;

each first power line is connected to the ninth bridge part intersecting with an orthographic projection of the first power line on the base substrate through a via hole.

In an exemplary embodiment of the present disclosure, a conductive layer provided with the third initial signal line is located on a side, away from the base substrate, of another conductive layer provided with the enable signal line; and a sheet resistance of the conductive layer provided with the third initial signal line is less than a sheet resistance of the another conductive layer provided with the enable signal line.

In an exemplary embodiment of the present disclosure, the display panel further includes a plurality of repeating units distributed along the first direction and the second direction, the repeating units including a first pixel drive circuit and a second pixel drive circuit distributed in the first direction, and the first pixel drive circuit and the second pixel drive circuit are at least partially arranged in a mirror-symmetrical manner.

In an exemplary embodiment of the present disclosure, the first extension part includes a first sub-extension part and a second sub-extension part, a size of an orthographic projection of the first sub-extension part on the base substrate in the second direction is less than a size of an orthographic projection of the second sub-extension part on the base substrate in the second direction;

an orthographic projection of the first power line on the base substrate extends along the second direction and at least partially overlaps with the orthographic projection of the first sub-extension part on the base substrate.

In an exemplary embodiment of the present disclosure, the display panel further includes a light-emitting unit, and the pixel drive circuit is configured to drive the light-emitting unit to emit light;

the pixel drive circuit further includes a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit;
the display panel further includes:
a first active layer on the side of the base substrate, the first active layer including a first active part and a seventh active part, the first active part being configured to form a channel region of the first transistor, and the seventh active part being configured to form a channel region of the seventh transistor; and
a first conductive layer on a side of the first active layer away from the base substrate, the first conductive layer including a first reset signal line and a second reset signal line, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor;
an orthographic projection of the first initial signal line on the base substrate at least partially overlaps with the orthographic projection of the second reset signal line on the base substrate in an adjacent previous row of the pixel drive circuit;
an orthographic projection of the second initial signal line on the base substrate at least partially overlaps with the orthographic projection of the first reset signal line on the base substrate in the adjacent previous row of the pixel drive circuit.

In an exemplary embodiment of the present disclosure, the pixel drive circuit further includes a second transistor, a first electrode of the second transistor being connected to a gate electrode of the drive transistor, and a second electrode of the second transistor being connected to a second electrode of the drive transistor;

the display panel further includes:
a first active layer on the side of the base substrate;
a first conductive layer on a side of the first active layer away from the base substrate;
a second active layer on a side of the first conductive layer away from the first active layer, the second active layer including a second active part, and the second active part being configured to form a channel region of the second transistor;
a third conductive layer on a side of the second active layer away from the base substrate, the third conductive layer including a first gate line, an orthographic projection of the first gate line on the base substrate extending along the first direction and covering an orthographic projection of the second active part on the base substrate, and a partial structure of the first gate line being configured to form a gate electrode of the second transistor;
a fourth conductive layer on a side of the third conductive layer away from the base substrate; and
a fifth conductive layer on a side of the fourth conductive layer away from the base substrate.

In an exemplary embodiment of the present disclosure, the display panel further includes a light-emitting unit, and the pixel drive circuit is configured to drive the light-emitting unit to emit light;

the pixel drive circuit further includes:
a first transistor having a first electrode connected to a first initial signal line and a second electrode connected to a second electrode of the drive transistor;
a second transistor having a first electrode connected to a gate electrode of the drive transistor and a second electrode connected to the second electrode of the drive transistor;
a fourth transistor having a first electrode connected to a data line and a second electrode connected to the first electrode of the drive transistor;
a sixth transistor having a first electrode connected to the second electrode of the drive transistor and a second electrode connected to a first electrode of the light-emitting unit;
a seventh transistor having a first electrode connected to a second initial signal line and a second electrode connected to the first electrode of the light-emitting unit; and
a capacitor having a first electrode connected to the gate electrode of the drive transistor and a second electrode connected to the first power line,
wherein the first transistor, the drive transistor, the fourth transistor, the fifth transistor, the sixth transistor, the seventh transistor, and the eighth transistor are P-type transistors, and the second transistor is an N-type transistor.

In an exemplary embodiment of the present disclosure, the enable signal line outputs a plurality of pulse signals during a drive cycle of the pixel drive circuit.

According to another aspect of this disclosure, there is provided a display apparatus, including the above display panel.

It should be understood that the foregoing general description and the following detailed description are exemplary and explanatory only and are not restrictive of this disclosure.

## BRIEF DESCRIPTION OF THE DRAWINGS

The accompanying drawings, which are incorporated into and constitute a part of this specification, illustrate embodiments consistent with this disclosure, and serve to explain the principles of this disclosure together with the description. It is apparent that the drawings in the following description are merely some embodiments of this disclosure. For those skilled in the art, other drawings may be derived from these figures without creative effort.

FIG. 1 is a schematic structural view of an exemplary embodiment of a pixel drive circuit according to this disclosure.

FIG. 2 is a timing diagram of some nodes in an exemplary embodiment of the pixel drive circuit shown in FIG. 1.

FIG. 3 is a structural layout of an exemplary embodiment of a display panel according to this disclosure.

FIG. 4 is a structural layout of a first active layer in FIG. 3.

FIG. 5 is a structural layout of a first conductive layer in FIG. 3.

FIG. 6 is a structural layout of a second conductive layer in FIG. 3.

FIG. 7 is a structural layout of a second active layer in FIG. 3.

FIG. 8 is a structural layout of a third conductive layer in FIG. 3.

FIG. 9 is a structural layout of a fourth conductive layer in FIG. 3.

FIG. 10 is a structural layout of a fifth conductive layer in FIG. 3.

FIG. 11 is a structural layout of a sixth conductive layer in FIG. 3.

FIG. 12 is a structural layout of the first active layer and the first conductive layer in FIG. 3.

FIG. 13 is a structural layout of the first active layer, the first conductive layer, and the second conductive layer in FIG. 3.

FIG. 14 is a structural layout of the first active layer, the first conductive layer, the second conductive layer, and the second active layer in FIG. 3.

FIG. 15 is a structural layout of the first active layer, the first conductive layer, the second conductive layer, the second active layer, and the third conductive layer in FIG. 3.

FIG. 16 is a structural layout of the first active layer, the first conductive layer, the second conductive layer, the second active layer, the third conductive layer, and the fourth conductive layer in FIG. 3.

FIG. 17 is a structural layout of the first active layer, the first conductive layer, the second conductive layer, the second active layer, the third conductive layer, the fourth conductive layer, and the fifth conductive layer in FIG. 3.

FIG. 18 is a partial sectional view of the display panel shown in FIG. 3 taken along a dotted line BB.

FIG. 19 is a schematic structural view of another exemplary embodiment of a display panel according to this disclosure.

FIG. 20 is a structural layout of a fourth conductive layer in the display panel shown in FIG. 19.

FIG. 21 is a schematic structural view of another exemplary embodiment of a display panel according to this disclosure.

FIG. 22 is a structural layout of a conductive layer provided with a third initial signal line in the display panel shown in FIG. 21.

**DETAILED DESCRIPTION**

Exemplary embodiments of the present disclosure will be now described more fully with reference to the accompanying drawings. However, the exemplary embodiments can be embodied in a variety of forms and should not be construed as limiting the embodiments set forth herein. Instead, these embodiments are provided so that this disclosure will be thorough and complete, and the concepts of the exemplary embodiments will be fully given to those skilled in the art. Same reference numbers denote the same or similar structures in the figures, and thus the detailed description thereof will be omitted.

Words such as "one," "an/a," and "said" are used herein to indicate the presence of one or more elements/component parts/and others. Terms "including" and "having" have an inclusive meaning which means that there may be additional elements/component parts/and others in addition to the listed elements/component parts/and others.

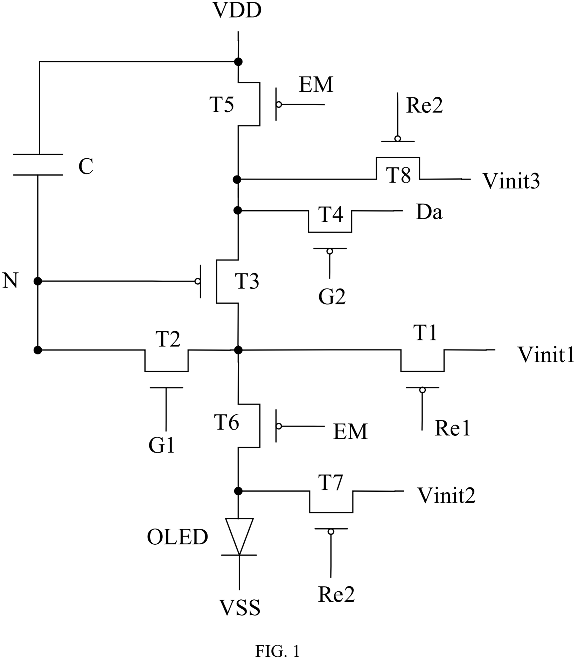

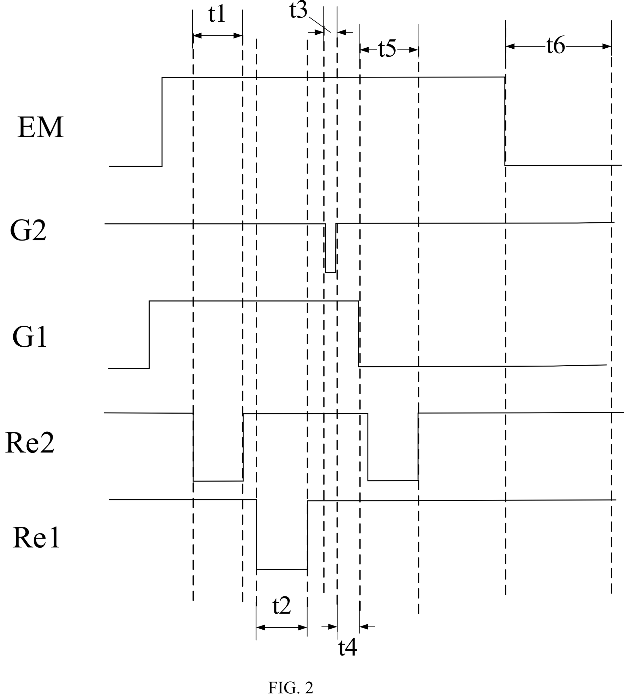

Exemplary embodiments first provide a pixel drive circuit, as shown in FIGS. 1 and 2. FIG. 1 is a schematic structural view of an exemplary embodiment of a pixel drive circuit according to this disclosure, and FIG. 2 is a timing diagram of some nodes in the exemplary embodiment of the pixel drive circuit shown in FIG. 1.

The pixel drive circuit may include a drive transistor T3, a first transistor T1, a second transistor T2, a fourth transistor T4, a fifth transistor T5, a sixth transistor T6, a seventh transistor T7, an eighth transistor T8, and a capacitor C. A first electrode of the fourth transistor T4 is connected to a data signal terminal Da, a second electrode of the fourth transistor T4 is connected to a first electrode of the drive transistor T3, and a gate electrode of the fourth transistor T4 is connected to a second gate driving signal terminal G2. A first electrode of the fifth transistor T5 is connected to a first power terminal VDD, a second electrode of the fifth transistor T5 is connected to a first electrode of the drive transistor T3, and a gate electrode of the fifth transistor T5 is connected to an enable signal terminal EM. A gate electrode of the drive transistor T3 is connected to a node N. A first electrode of the second transistor T2 is connected to the node N, a second electrode of the second transistor T2 is connected to a second electrode of the drive transistor T3, and a gate electrode of the second transistor T2 is connected to a first gate driving signal terminal G1. A first electrode of the sixth transistor T6 is connected to the second electrode of the drive transistor T3, a second electrode of the sixth transistor T6 is connected to a second electrode of the seventh transistor T7, and a gate electrode of the sixth transistor T6 is connected to the enable signal terminal EM. A first electrode of the seventh transistor T7 is connected to a second initial signal terminal Vinit2, and a gate electrode of the seventh transistor T7 is connected to a second reset signal terminal Re2. A first electrode of the first transistor T1 is connected to a first initial signal terminal Vinit1, a second electrode of the first transistor T1 is connected to the second electrode of the drive transistor T3, and a gate electrode of the first transistor T1 is connected to a first reset signal terminal Re1. A first electrode of the eighth transistor T8 is connected to a third initial signal terminal Vinit3, a second electrode of the eighth transistor T8 is connected to a first electrode of the drive transistor T3, and a gate electrode of the eighth transistor T8 is connected to the second reset signal terminal Re2. A first electrode of the capacitor C is connected to the node N, and a second electrode of the capacitor C is connected to a first power terminal VDD. The pixel drive circuit may be configured to drive a light-emitting unit OLED. A first electrode of the light-emitting unit OLED may be connected to the second electrode of the sixth transistor T6, and the second electrode of the light-emitting unit may be connected to a second power terminal VSS. The first electrode of the light-emitting unit may be an anode of the light-emitting unit, and the second electrode of the light-emitting unit may be a cathode of the light-emitting unit. The second transistor T2 may be an N-type transistor, for example, the second transistor T2 may be an N-type metal oxide transistor. The N-type transistor has a small leakage current, thereby avoiding leakage of the node N through the second transistor T2 during the light-emitting phase. Meanwhile, the first transistor T1, the drive transistor T3, the fourth transistor T4, the fifth transistor T5, the sixth transistor T6, the seventh transistor T7, and the eighth transistor T8 may be P-type transistors, for example, the drive transistor T3, the fourth transistor T4, the fifth transistor T5, the sixth transistor T6, the seventh transistor T7, and the eighth transistor T8 may be P-type transistors, such as P-type low-temperature polycrystalline silicon transistors. The P-type transistors have a high carrier mobility, which is beneficial for realizing a display panel with high resolution, high response speed, high pixel density, and high aperture ratio. The first initial signal terminal, the second initial signal terminal, and the third initial signal terminal may output same or different voltage signals according to actual conditions.

As shown in FIG. 2, G1 represents a timing of the first gate driving signal terminal G1, G2 represents a timing of the second gate driving signal terminal G2, Re2 represents a timing of the second reset signal terminal Re2, Re1 represents a timing of the first reset signal terminal Re1, and EM represents a timing of the enable signal terminal EM. One drive cycle of the pixel drive circuit may include a first reset phase t1, a second reset phase t2, a data writing phase t3, a third reset phase t5, and a light-emitting phase t6.

In the first reset phase t1, the second reset signal terminal Re2 outputs a low-level signal, the seventh transistor T7 and the eighth transistor T8 are turned on, the second initial signal terminal Vinit2 inputs a second initial signal to the first electrode of the light-emitting unit OLED, and the third initial signal terminal Vinit3 inputs a third initial signal to the first electrode of the drive transistor T3 to improve a hysteresis issue of the drive transistor T3. In the second reset phase t2, the first gate driving signal terminal G1 outputs a high-level signal, the first reset signal terminal Re1 outputs a low-level signal, the first transistor T1 and the second transistor T2 are turned on, and the first initial signal terminal Vinit1 inputs a first initial signal to the node N through the first transistor T1 and the second transistor T2. In the data writing phase t3, the second gate driving signal terminal G2 outputs a low-level signal, the first gate driving signal terminal G1 outputs a high-level signal, the fourth transistor T4 and the second transistor T2 are turned on, and the data signal terminal Da writes a compensation voltage Vdata+Vth to the node N through the fourth transistor T4 and the second transistor T2, where Vdata is a voltage of a data signal on the data signal terminal, and Vth is a threshold voltage of the drive transistor T3. In the third reset phase t5, the second reset signal terminal Re2 outputs a low-level signal, the seventh transistor T7 and the eighth transistor T8 are turned on, the second initial signal terminal Vinit2 inputs a second initial signal to the first electrode of the light-emitting unit OLED, and the third initial signal terminal Vinit3 inputs a third initial signal to the first electrode of the drive transistor T3. In the light-emitting phase t6, the enable signal terminal EM outputs a low-level signal, the sixth transistor T6 and the fifth transistor T5 are turned on, and the drive transistor T3 drives the light-emitting unit to emit light under the action of the compensation voltage Vdata+Vth stored in the capacitor C. A formula for an output current of the drive transistor is as follows:

$$I = (\mu W Cox/2L)(Vgs - Vth)^2$$

where I is the output current of the drive transistor; $\mu$ is a carrier mobility; Cox is a gate capacitance per unit area; W is a channel width of the drive transistor; L is a channel length of the drive transistor; Vgs is a gate-source voltage difference of the drive transistor; and Vth is a threshold voltage of the drive transistor. The output current I of the drive transistor in the pixel drive circuit is $I = (\mu W Cox/2L)(Vdata + Vth - Vdd - Vth)^2$. The pixel drive circuit may avoid the influence of the threshold voltage of the drive transistor on the output current thereof.

In the related art, the display quality of the display panel may be improved by increasing the number of high-level pulse signals of the enable signal terminal EM in one drive cycle of the pixel drive circuit. In the related art, the enable signal terminal is provided through an enable signal line, and a large parasitic capacitance is formed between the third initial signal line providing the third initial signal terminal and the enable signal line. When the number of pulse signals on the enable signal line is large, the enable signal line may play a coupling function on the third initial signal line, to cause frequent voltage changes on the third initial signal line, and thus lead to issues such as horizontal stripes or splitting screens on the display panel.

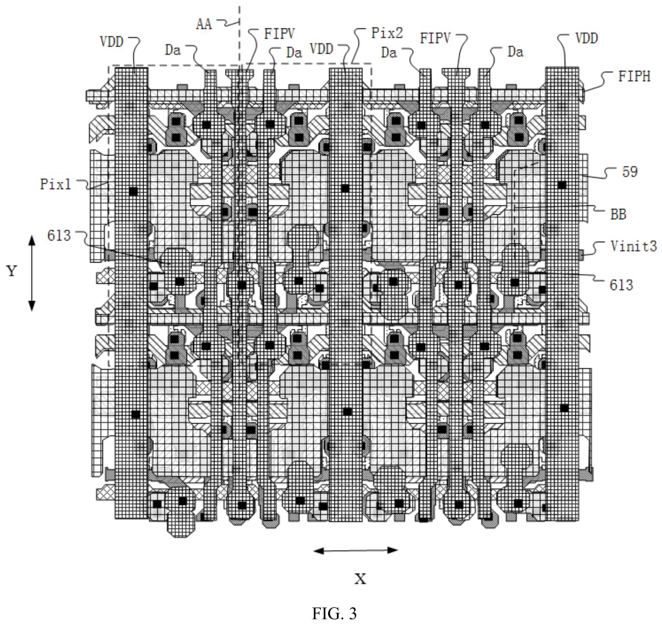

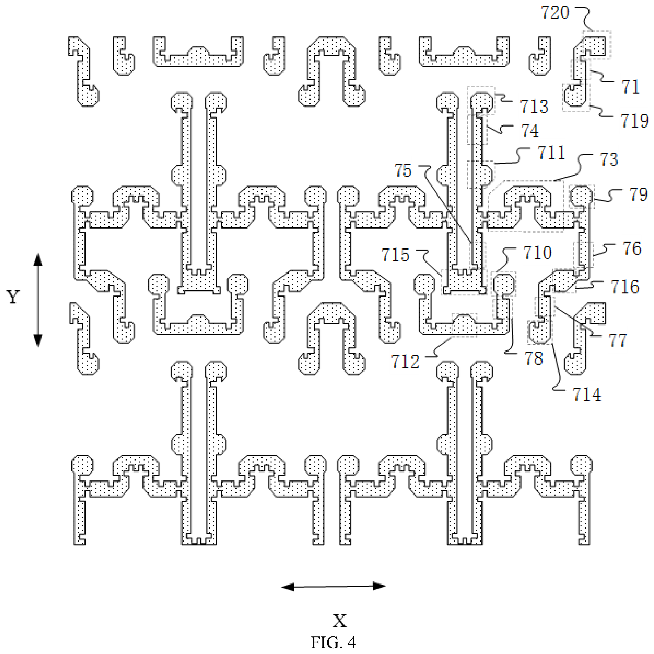

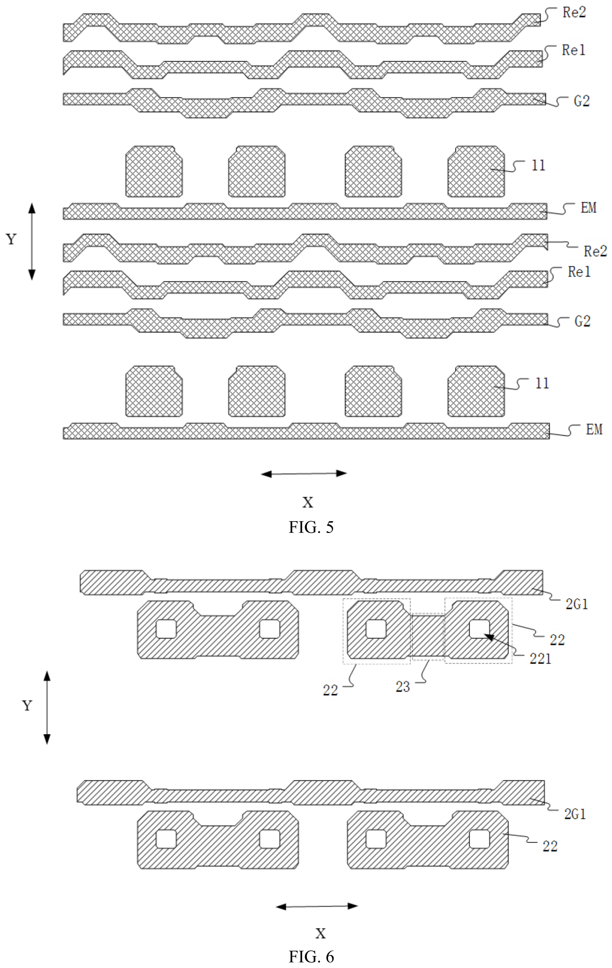

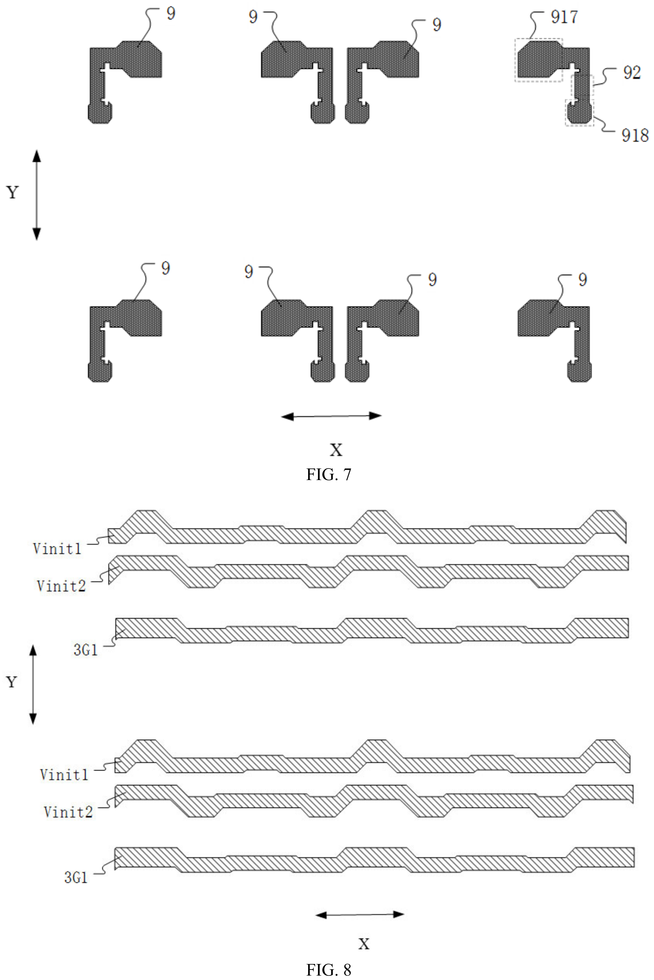

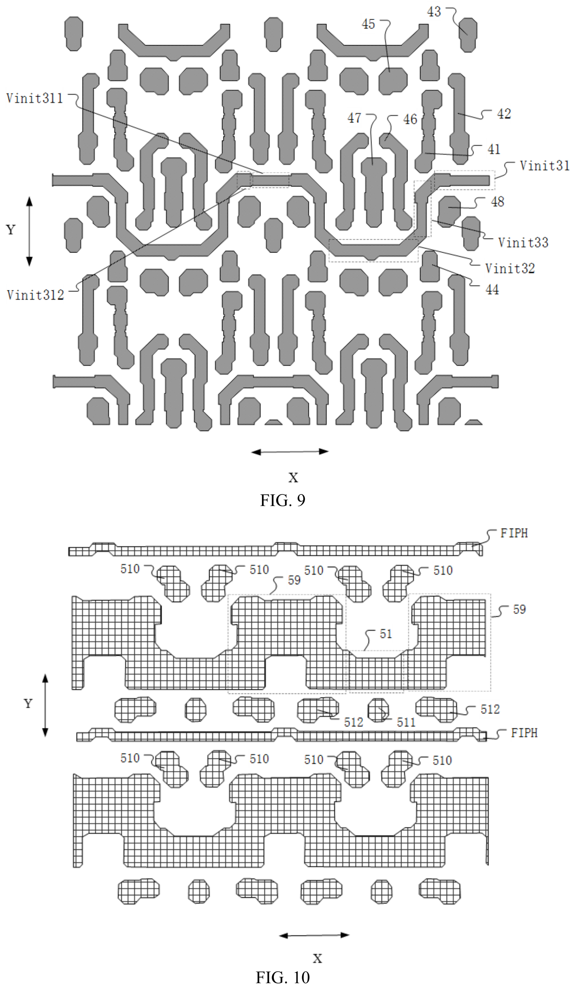

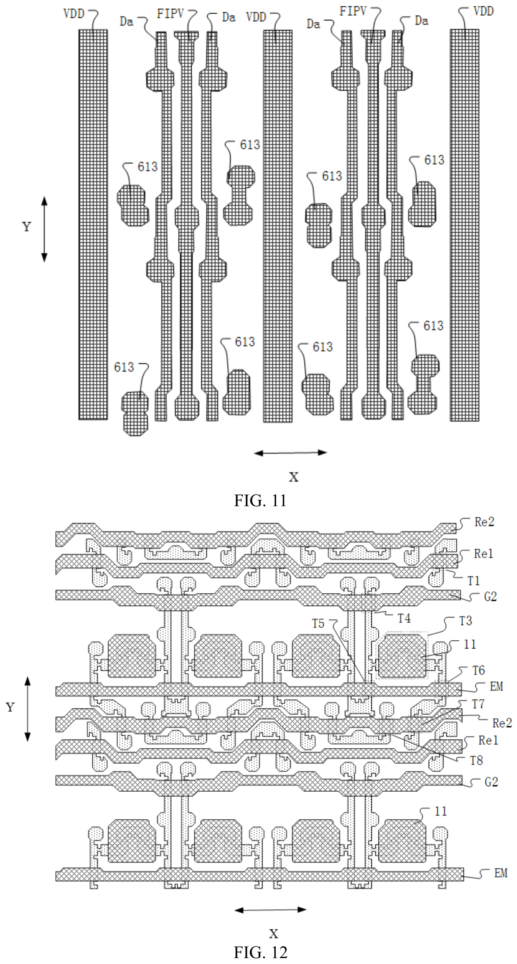

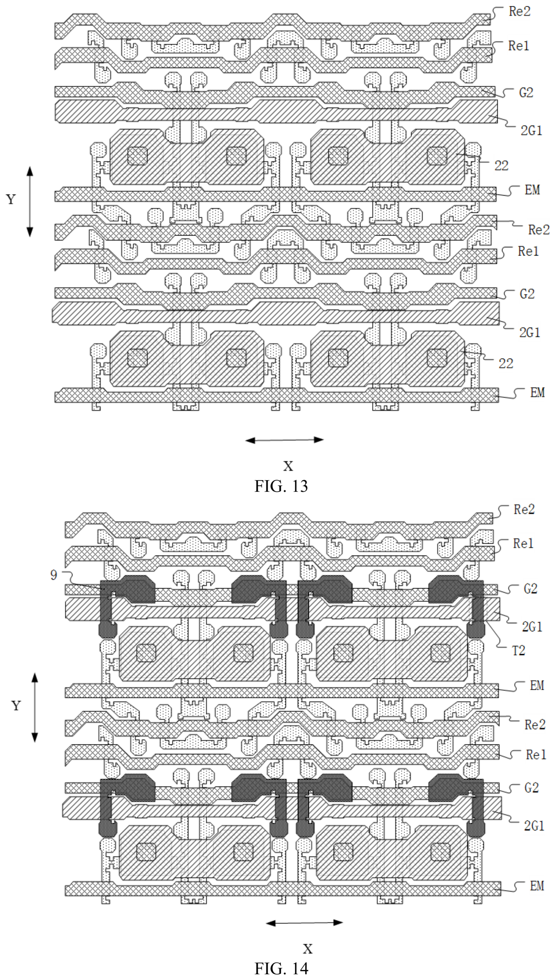

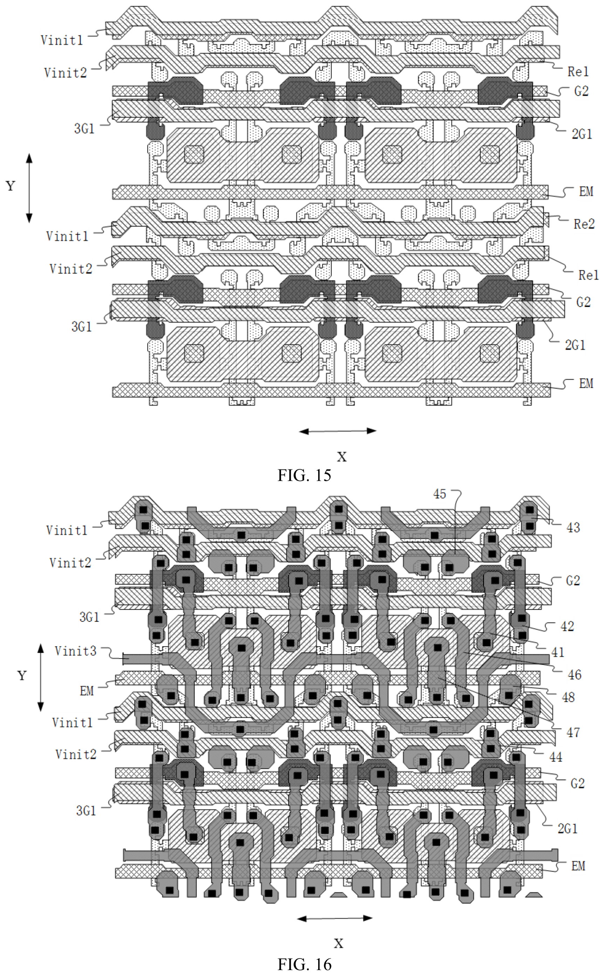

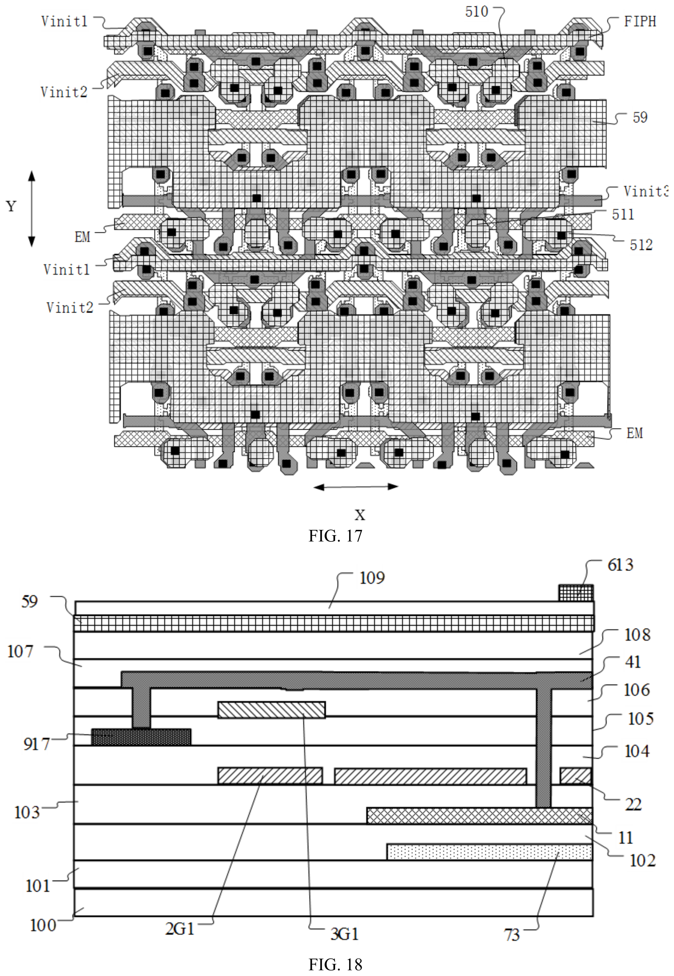

On this basis, exemplary embodiments of the present disclosure also provide a display panel. The display panel may include a base substrate, a first active layer, a first conductive layer, a second conductive layer, a second active layer, a third conductive layer, a fourth conductive layer, a fifth conductive layer, and a sixth conductive layer stacked in sequence. Insulating layers may be provided between the above adjacent layers. As shown in FIGS. 3-17, FIG. 3 is a structural layout of an exemplary embodiment of the display panel according to this disclosure; FIG. 4 is a structural layout of the first active layer in FIG. 3; FIG. 5 is a structural layout of the first conductive layer in FIG. 3; FIG. 6 is a structural layout of the second conductive layer in FIG. 3; FIG. 7 is a structural layout of the second active layer in FIG. 3; FIG. 8 is a structural layout of the third conductive layer in FIG. 3; FIG. 9 is a structural layout of the fourth conductive layer in FIG. 3; FIG. 10 is a structural layout of the fifth conductive layer in FIG. 3; FIG. 11 is a structural layout of the sixth conductive layer in FIG. 3; FIG. 12 is a structural layout of the first active layer and the first conductive layer in FIG. 3; FIG. 13 is a structural layout of the first active layer, the first conductive layer, and the second conductive layer in FIG. 3; FIG. 14 is a structural layout of the first active layer, the first conductive layer, the second conductive layer, and the second active layer in FIG. 3; FIG. 15 is a structural layout of the first active layer, the first conductive layer, the second conductive layer, the second active layer, and the third conductive layer in FIG. 3; FIG. 16 is a structural layout of the first active layer, the first conductive layer, the second conductive layer, the second active layer, the third conductive layer, and the fourth conductive layer in FIG. 3; and FIG. 17 is a structural layout of the first active layer, the first conductive layer, the second conductive layer, the second active layer, the third conductive layer, the fourth conductive layer, and the fifth conductive layer in FIG. 3. The display panel may include a plurality of pixel drive circuits as shown in FIG. 1. As shown in FIG. 3, the display panel may include a plurality of repeating units distributed in a first direction X and a second direction Y. The repeating unit may include a first pixel drive circuit Pix1 and a second pixel drive circuit Pix2, which are adjacent to each other in the first direction X. The first pixel drive circuit Pix1 and the second pixel drive circuit Pix2 may be at least partially structurally arranged in a mirror-symmetrical manner with respect to a mirror symmetry plane AA. The mirror symmetry plane AA may be perpendicular to the base substrate. An orthographic projection of the first pixel drive circuit Pix1 on the base substrate and an orthographic projection of the second pixel drive circuit Pix2 on the base substrate may be at least partially symmetrically arranged with respect to an intersection line of the mirror symmetry plane AA and the base substrate. The first direction X intersects with the second direction Y, for example, the first direction X may be a row direction, and the second direction Y may be a column direction.

As shown in FIGS. 3, 4, and 12, the first active layer may include a first active part 71, a third active part 73, a fourth active part 74, a fifth active part 75, a sixth active part 76, a seventh active part 77, an eighth active part 78, a ninth active part 79, a tenth active part 710, an eleventh active part 711, a twelfth active part 712, a thirteenth active part 713, a fourteenth active part 714, a fifteenth active part 715, a sixteenth active part 716, a nineteenth active part 719, and a twentieth active part 720. The first active part 71 is configured to form a channel region of the first transistor T1. The third active part 73 may be configured to form a channel region of the drive transistor T3. The fourth active part 74 may be configured to form a channel region of the fourth transistor T4. The fifth active part 75 may be configured to form a channel region of the fifth transistor T5. The sixth active part 76 may be configured to form a channel region of the sixth transistor T6. The seventh active part 77 may be configured to form a channel region of the seventh transistor T7. The eighth active part 78 may be configured to form a channel region of the eighth transistor T8. The ninth active part 79 is connected between the third active part 73 and the sixth active part 76. The tenth active part 710 and the twelfth active part 712 are connected to both ends of the eighth active part 78. The eleventh active part 711 is connected between the fourth active part 74 and the third active part 73. The thirteenth active part 713 is connected to a side of the fourth active part 74 away from the third active part 73. The fourteenth active part 714 is connected to a side of the seventh active part 77 away from the sixth active part 76. The fifteenth active part 715 is connected to a side of the fifth active part 75 away from the third active part 73. The sixteenth active part 716 is connected between the seventh active part 77 and the sixth active part 76. The nineteenth active part 719 and the twentieth active part 720 are connected to both ends of the first active part 71. The first active layer may be formed of polycrystalline silicon materials. Accordingly, the first transistor T1, the drive transistor T3, the fourth transistor T4, the fifth transistor T5, the sixth transistor T6, the seventh transistor T7, and the eighth transistor T8 may be P-type low-temperature polycrystalline silicon thin-film transistors.

As shown in FIGS. 3, 5, and 12, the first conductive layer may include a first conductive part 11, a second gate line G2, an enable signal line EM, a first reset signal line Re1, and a second reset signal line Re2. The second gate line G2 may be configured to provide the second gate driving signal terminal in FIG. 1. The enable signal line EM may be configured to provide the enable signal terminal in FIG. 1. The first reset signal line Re1 may be configured to provide the first reset signal terminal in FIG. 1. The second reset signal line Re2 may be configured to provide the second reset signal terminal in FIG. 1. An orthographic projection of the second gate line G2 on the base substrate, an orthographic projection of the enable signal line EM on the base substrate, an orthographic projection of the first reset signal line Re1 on the base substrate, and an orthographic projection of the second reset signal line Re2 on the base substrate may all extend along the first direction X. The orthographic projection of the second gate line G2 on the base substrate covers the orthographic projection of the fourth active part 74 on the base substrate, and part of the structure of the second gate line G2 is configured to form the gate electrode of the fourth transistor. The orthographic projection of the enable signal line EM on the base substrate covers the orthographic projection of the fifth active part 75 on the base substrate and the orthographic projection of the sixth active part 76 on the base substrate. Part of the structure of the enable signal line EM may be configured to form the gate electrodes of the fifth transistor T5 and the sixth transistor T6, respectively. The orthographic projection of the first reset signal line Re1 on the base substrate may cover the orthographic projection of the first active part 71 on the base substrate, and part of the structure of the first reset signal line Re1 is configured to form the gate electrode of the first transistor T1. The orthographic projection of the second reset signal line Re2 on the base substrate may cover the orthographic projection of the seventh active part 77 on the base substrate and the orthographic projection of the eighth active part 78 on the base substrate. Part of the structure of the first reset signal line Re1 may be configured to form the gate electrodes of the seventh transistor T7 and the eighth transistor T8, respectively. An orthographic projection of the first conductive part 11 on the base substrate covers the orthographic projection of the third active part 73 on the base substrate. The first conductive part 11 may be configured to form the gate electrode of the drive transistor T3 and the first electrode of the capacitor C. The display panel may use the first conductive layer as a mask to make the first active layer conductive, that is, a region of the first active layer covered by the first conductive layer may form the channel region of the transistor, and the region of the first active layer not covered by the first conductive layer may form a conductor structure.

As shown in FIGS. 3, 6, and 13, the second conductive layer may include a third gate line 2G1 and a second conductive part 22. An orthographic projection of the third gate line 2G1 on the base substrate extends along the first direction X. The third gate line 2G1 may be configured to provide the first gate driving signal terminal in FIG. 1. An orthographic projection of the second conductive part 22 on the base substrate may at least partially overlap with the orthographic projection of the first conductive part 11 on the base substrate. The second conductive part 22 is configured to form the second electrode of the capacitor C. The second conductive layer may further include a second connection part 23. The adjacent second conductive parts 22 in the first direction X may be connected through the second connection part 23.

As shown in FIGS. 3, 7, and 14, the second active layer may include an active part 9. The active part 9 may include a second active part 92, a seventeenth active part 917 and an eighteenth active part 918 connected to both ends of the second active part 92. The second active part 92 is configured to form a channel region of the second transistor T2. The second active layer may be formed of indium gallium zinc oxide (IGZO). Accordingly, the second transistor T2 may be an N-type metal oxide thin-film transistor. The orthographic projection of the third gate line 2G1 on the base substrate may cover an orthographic projection of the second active part 92 on the base substrate. Part of the structure of the third gate line 2G1 may be configured to form a bottom gate of the second transistor T2.

As shown in FIGS. 3, 8, and 15, the third conductive layer may include a first gate line 3G1, a first initial signal line Vinit1, and a second initial signal line Vinit2. An orthographic projection of the first gate line 3G1 on the base substrate, an orthographic projection of the first initial signal line Vinit1 on the base substrate, and an orthographic projection of the second initial signal line Vinit2 on the base substrate may all extend along the first direction X. The first gate line 3G1 may be configured to provide the first gate driving signal terminal in FIG. 1. The orthographic projection of the first gate line 3G1 on the base substrate may cover the orthographic projection of the second active part 92 on the base substrate. Part of the structure of the first gate line 3G1 may be configured to form a top gate of the second transistor T2. Meanwhile, the first gate line 3G1 may be connected to the third gate line 2G1 through a via hole in a border area of the display panel. The first initial signal line Vinit1 may be configured to provide the first initial signal terminal in FIG. 1, and the second initial signal line Vinit2 may be configured to provide the second initial signal terminal in FIG. 1. The orthographic projection of the first initial signal line Vinit1 on the base substrate may at least partially overlap with the orthographic projection of the second reset signal line Re2 on the base substrate in an adjacent upper row of the pixel drive circuits. The orthographic projection of the second initial signal line Vinit2 on the base substrate may at least partially overlap with the orthographic projection of the first reset signal line Re1 on the base substrate in the adjacent lower row of the pixel drive circuit. This arrangement may improve the light transmittance and integration of the display panel. Additionally, the display panel may use the third conductive layer as a mask to make the second active layer conductive, that is, a region of the second active layer covered by the third conductive layer may form a channel region of the transistor, and a region of the second active layer not covered by the third conductive layer may form a conductor structure.

As shown in FIGS. 3, 9, and 16, the fourth conductive layer may include a first bridge part 41, a second bridge part 42, a third bridge part 43, a fourth bridge part 44, a fifth bridge part 45, a sixth bridge part 46, a seventh bridge part 47, an eighth bridge part 48, and a third initial signal line Vinit3. The first bridge part 41 is respectively connected to the seventeenth active part 917 and the first conductive part 11 through via holes, to connect the gate electrode of the drive transistor T3 and the first electrode of the second transistor T2. An opening 221 may be formed on the second conductive part 22, and a via hole connecting the first bridge part 41 and the first conductive part 11 is disposed through the opening 221. The second bridge part 42 may be respectively connected to the ninth active part 79, the eighteenth active part 918, and the nineteenth active part 719 through via holes, to connect the second electrode of the first transistor T1, the second electrode of the second transistor T2, and the second electrode of the drive transistor T3. The third bridge part 43 is respectively connected to the twentieth active part 720 and the first initial signal line Vinit1 through via holes, to connect the first electrode of the first transistor T1 and the first initial signal terminal. The fourth bridge part 44 is respectively connected to the fourteenth active part 714 and the second initial signal line Vinit2 through via holes, to connect the first electrode of the seventh transistor T7 and the second initial signal line. The fifth bridge part 45 is connected to the thirteenth active part 713 through a via hole to connect the first electrode of the fourth transistor T4. The sixth bridge part 46 is respectively connected to the eleventh active part 711 and the tenth active part 710 through via holes, to connect the second electrode of the eighth transistor T8 and the first electrode of the drive transistor T3. The seventh bridge part 47 is respectively connected to the second connection part 23 and the fifteenth active part 715 through via holes, to connect the second electrode of the capacitor C and the first electrode of the fifth transistor T5. The eighth bridge part 48 is connected to the sixteenth active part 716 through a via hole to connect the second electrode of the seventh transistor T7 and the second electrode of the sixth transistor T6.

As shown in FIGS. 3, 9, and 16, an orthographic projection of the third initial signal line Vinit3 on the base substrate extends along the first direction X. The third initial signal line Vinit3 includes a first extension part Vinit31, a second extension part Vinit32, and a third extension part Vinit33. The third extension part Vinit33 is connected between the first extension part Vinit31 and the second extension part Vinit32. An orthographic projection of the first extension part Vinit31 on the base substrate and an orthographic projection of the second extension part Vinit32 on the base substrate extend along the first direction X and are staggered in the second direction Y. An orthographic projection of the first extension part Vinit31 on the base substrate does not intersect with the orthographic projection of the enable signal line EM on the base substrate, and the orthographic projection of the second extension part Vinit32 on the base substrate does not intersect with the orthographic projection of the enable signal line EM on the base substrate. This arrangement may reduce an overlapping area between the third initial signal line Vinit3 and the enable signal line EM, thereby reducing parasitic capacitance between the third initial signal line Vinit3 and the enable signal line EM, and improving issues such as horizontal stripes or splitting screens caused by voltage changes on the third initial signal line Vinit3.

As shown in FIGS. 3, 9, and 16, the orthographic projection of the enable signal line EM on the base substrate is located between the orthographic projection of the first extension part Vinit31 on the base substrate and the orthographic projection of the second extension part Vinit32 on the base substrate. The orthographic projection of the third extension part Vinit33 on the base substrate may intersect with the orthographic projection of the enable signal line EM on the base substrate.

In this exemplary embodiment, the enable signal line EM is located in the first conductive layer. It should be understood that, in other exemplary embodiments, the enable signal line EM may also be located in other conductive layers. For example, the enable signal line EM may be connected to the gate electrode of the fifth transistor through a via hole.

In this exemplary embodiment, in the same pixel drive circuit, the orthographic projection of the first extension part Vinit31 on the base substrate may be located between the orthographic projection of the enable signal line EM on the base substrate and an orthographic projection of the first bridge part 41 on the base substrate.

In this exemplary embodiment, in the same pixel drive circuit, at least part of the orthographic projection of the second extension part Vinit32 on the base substrate is located on a side of the orthographic projection of the second reset signal line Re2 on the base substrate away from the orthographic projection of the enable signal line EM on the base substrate. This arrangement may reduce a coupling effect of the second reset signal line Re2 on the second extension part Vinit32.

In this exemplary embodiment, in the same pixel drive circuit, at least part of the orthographic projection of the third extension part Vinit33 on the base substrate is located between the orthographic projection of the sixth active part 76 on the base substrate and the orthographic projection of the eighth active part 78 on the base substrate in the first direction X.

As shown in FIGS. 3, 10, and 17, the fifth conductive layer may include a ninth bridge part, a first connection part 51, a tenth bridge part 510, an eleventh conductive part 511, a twelfth bridge part 512, and a first fan-out line FIPH. An orthographic projection of the first fan-out line FIPH on the base substrate may extend along the first direction X. The first fan-out line FIPH may serve as a row-direction fan-out line connecting data lines in a FIP (Fanout In Pixel) region. The ninth bridge part may be connected to the seventh bridge part 47 through a via hole to connect the first electrode of the fifth transistor T5. The fifth conductive layer includes a plurality of ninth bridge parts 59 and a plurality of first connection parts 51. The plurality of ninth bridge parts 59 are distributed in the first direction X and the second direction Y, and the first connection part 51 is connected between two adjacent ninth bridge parts 59 in the first direction X. The tenth bridge part 510 may be connected to the fifth bridge part 45 through a via hole to connect the first electrode of the fourth transistor. The twelfth bridge part 512 may be connected to the eighth bridge part 48 through a via hole to connect the second electrode of the sixth transistor T6. Part of the eleventh conductive part 511 may be connected to the first fan-out line FIPH in the same layer. The first fan-out line FIPH may be connected to a column-direction data fan-out line through the eleventh conductive part 511 and a via hole. The part of the eleventh conductive part 511 may be spaced apart from the first fan-out line FIPH. The column-direction data fan-out line is also connected to the part of the eleventh conductive part 511 through a via hole. The part of the eleventh conductive part 511 may make light reflection and light transmission characteristics at different positions of the display panel uniform.

As shown in FIGS. 3 and 11, the sixth conductive layer may include a data line Da, a first power line VDD, a second fan-out line FIPV, and a thirteenth bridge part 613. Orthographic projections of the data line Da, the first power line VDD, and the second fan-out line FIPV on the base substrate may extend along the second direction Y. The data line Da is configured to provide a data signal terminal in FIG. 1, and the first power line VDD is configured to provide the first power terminal in FIG. 1. The data line Da may be connected to the tenth bridge part 510 through a via hole to connect the data signal terminal and the first electrode of the fourth transistor. The first power line VDD may include a plurality of lines. The orthographic projections of the plurality of first power lines VDD on the base substrate extend along the second direction Y and are spaced apart in the first direction X. The first power line VDD may be connected to the ninth bridge part 59 through a via hole, which intersects with the orthographic projection of the first power line VDD on the base substrate. The first power line VDD and the ninth bridge part 59 connected in the first direction X may form a grid structure. This arrangement may reduce voltage difference on the first power line at different positions of the display panel, thereby improving display uniformity of the display panel.

The second fan-out line FIPV may serve as a column-direction fan-out line connecting data lines in a FIP (Fanout In Pixel) region. The second fan-out line FIPV may be connected to the eleventh conductive part 511 through a via hole. The thirteenth bridge part 613 may be connected to the twelfth bridge part 512 through a via hole. The thirteenth bridge part 613 may also be connected to the first electrode of the light-emitting unit.

As shown in FIGS. 3 and 11, an orthographic projection of the ninth bridge part 59 on the base substrate may cover the orthographic projection of the second active part 92 on the base substrate. The ninth bridge part 59 may reduce the influence of light on characteristics of the second transistor T2. The orthographic projection of the ninth bridge part 59 on the base substrate may also at least partially overlap with the orthographic projection of the first bridge part 41 on the base substrate. The ninth bridge part 59 may shield noise interference from other signals on the first bridge part 41, thereby improving the stability of the voltage of the gate electrode of the drive transistor T3.

As shown in FIGS. 3 and 11, the orthographic projection of the first power line VDD on the base substrate and the orthographic projection of the third extension part Vinit33 on the base substrate both extend along the second direction Y, and the orthographic projection of the first power line VDD on the base substrate does not overlap with the orthographic projection of the third extension part Vinit33 on the base substrate. This arrangement may reduce the parasitic capacitance between the third initial signal line Vinit3 and the first power line VDD, thereby reducing mutual coupling effect between the third initial signal line Vinit3 and the first power line VDD.

As shown in FIGS. 3, 9, and 11, the first extension part Vinit31 includes a first sub-extension part Vinit311 and a second sub-extension part Vinit312. A size of the orthographic projection of the first sub-extension part Vinit311 on the base substrate in the second direction Y is smaller than a size of the orthographic projection of the second sub-extension part Vinit312 on the base substrate in the second direction Y. The orthographic projection of the first power line VDD on the base substrate at least partially overlaps with the orthographic projection of the first sub-extension part Vinit311 on the base substrate. This arrangement may further reduce the parasitic capacitance between the third initial signal line Vinit3 and the first power line VDD.

It should be noted that, as shown in FIGS. 3, 16, and 17, black squares drawn on a side of the fourth conductive layer facing away from the base substrate represent via holes connecting the fourth conductive layer to other layers on a side facing the base substrate. The black squares drawn on a side of the fifth conductive layer facing away from the base substrate represent via holes connecting the fifth conductive layer to other layers on a side facing the base substrate. The black squares drawn on a side of the sixth conductive layer facing away from the base substrate represent via holes connecting the sixth conductive layer to other layers on a side facing the base substrate. The different black squares at different positions represent different via holes that may penetrate through different insulating layers.

As shown in FIG. 18, it is a partial sectional view of the display panel shown in FIG. 3 taken along a dotted line BB. The display panel may further include a buffer layer 101, a second insulating layer 102, a third insulating layer 103, a fourth insulating layer 104, a fifth insulating layer 105, a first dielectric layer 106, a passivation layer 107, a first planarization layer 108, and a second planarization layer 109. The base substrate 100, the buffer layer 101, the first active layer, the second insulating layer 102, the first conductive layer, the third insulating layer 103, the second conductive layer, the fourth insulating layer 104, the second active layer, the fifth insulating layer 105, the third conductive layer, the first dielectric layer 106, the fourth conductive layer, the passivation layer 107, the first planarization layer 108, the fifth conductive layer, the second planarization layer 109, and the sixth conductive layer are stacked in sequence. The buffer layer 101, the second insulating layer 102, the third insulating layer 103, the fourth insulating layer 104, and the fifth insulating layer 105 may be a single-layer structure or a multi-layer structure, and their materials may include at least one of silicon nitride, silicon oxide, or silicon oxynitride. The first dielectric layer 106 may be a silicon nitride layer. The materials of the first planarization layer 108 and the second planarization layer 109 may be organic materials, such as polyimide (PI), polyethylene terephthalate (PET), polyethylene naphthalate (PEN), or silicon-on-glass (SOG) structures. The passivation layer 97 may be a silicon oxide layer. The base substrate 90 may include a glass substrate, a barrier layer, and a polyimide layer stacked in sequence, where the barrier layer may be made of inorganic materials. The materials of the first conductive layer, the second conductive layer, and the third conductive layer may include one of molybdenum, aluminum, copper, titanium, and niobium, or alloys thereof, or molybdenum/titanium alloys or stacked layers. The materials of the fourth conductive layer, the fifth conductive layer, and the sixth conductive layer may include metal materials, such as molybdenum, aluminum, copper, titanium, niobium, or alloys thereof, or molybdenum/titanium alloys or stacked layers, or titanium/aluminum/titanium stacked layers. A sheet resistance of any one of the fourth conductive layer, the fifth conductive layer, and the sixth conductive layer may be lower than that of any one of the first conductive layer, the second conductive layer, and the third conductive layer. The display panel may further include an electrode layer and a light-emitting unit layer located on the side of the sixth conductive layer facing away from the base substrate.

In this exemplary embodiment, the third initial signal line Vinit3 is disposed in the fourth conductive layer with a lower sheet resistance. On the one hand, this arrangement may reduce an internal resistance of the third initial signal line Vinit3, thereby reducing the voltage difference at different positions of the third initial signal line Vinit3 and improving the display uniformity of the display panel. On the other hand, the distance between the third initial signal line Vinit3 and the enable signal line EM is relatively large, which may reduce the parasitic capacitance between the third initial signal line Vinit3 and the enable signal line EM, thereby reducing the coupling effect of the enable signal line EM on the third initial signal line Vinit3.

It should be understood that, in other exemplary embodiments, the third initial signal line Vinit3 may also be disposed in other conductive layers. For example, the conductive layer provided with the third initial signal line Vinit3 may be located on the side of the conductive layer provided with the enable signal line EM, facing away from the base substrate; and the sheet resistance of the conductive layer provided with the third initial signal line Vinit3 may be lower than that of the conductive layer provided with the enable signal line EM.

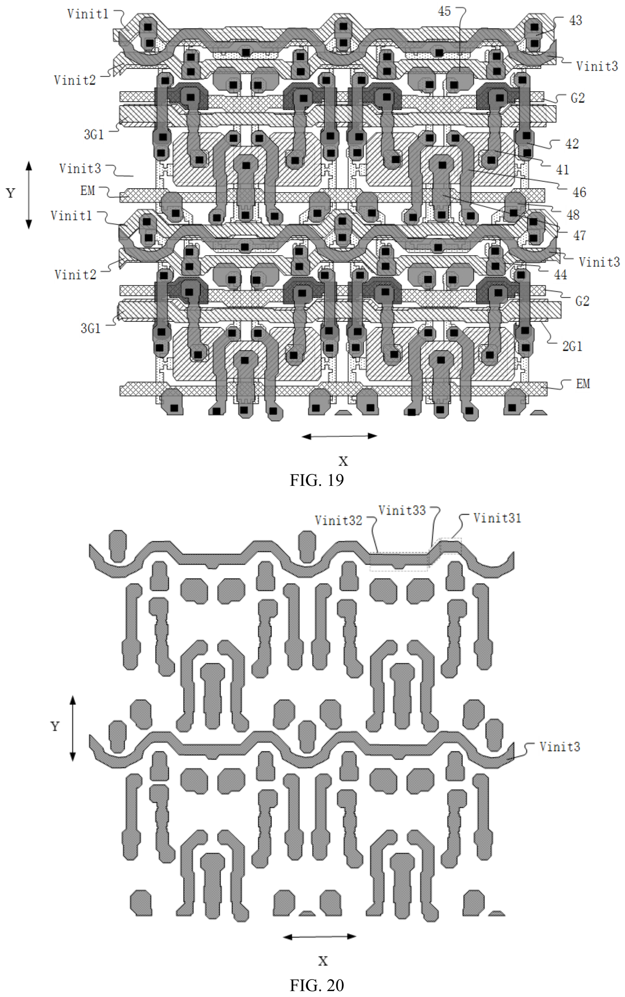

As shown in FIGS. 19 and 20, FIG. 19 is a schematic structural view of another exemplary embodiment of the display panel according to this disclosure, and FIG. 20 is a structural layout of the fourth conductive layer in the display panel shown in FIG. 19. The display panel shown in FIG. 19 differs from the display panel shown in FIG. 3 only in the fourth conductive layer. As shown in FIGS. 19 and 20, in the same pixel drive circuit, the orthographic projection of the third initial signal line Vinit3 on the base substrate is located on the side of the orthographic projection of the enable signal line EM on the base substrate facing away from the orthographic projection of the first conductive part 11 on the base substrate. This arrangement may also reduce the parasitic capacitance between the third initial signal line Vinit3 and the enable signal line EM, thereby improving the display performance of the display panel.

As shown in FIGS. 19 and 20, the orthographic projection of the first extension part Vinit31 on the base substrate at least partially overlaps with the orthographic projection of the second reset signal line Re2 on the base substrate in the same row of the pixel drive circuits. The orthographic projection of the second extension part Vinit32 on the base substrate is at least partially located between the orthographic projection of the first reset signal line Re1 on the base substrate in the adjacent lower row of the pixel drive circuits and the orthographic projection of the second reset signal line Re2 on the base substrate in the same row of the pixel drive circuits. This arrangement may allow the third initial signal line Vinit3 to avoid the third bridge part 43 and the fourth bridge part 44 but also reduce the overlapping area between the third initial signal line Vinit3 and the first reset signal line Re1 and the second reset signal line Re2, thereby reducing the coupling effect of the first reset signal line Re1 and the second reset signal line Re2 on the third initial signal line Vinit3.

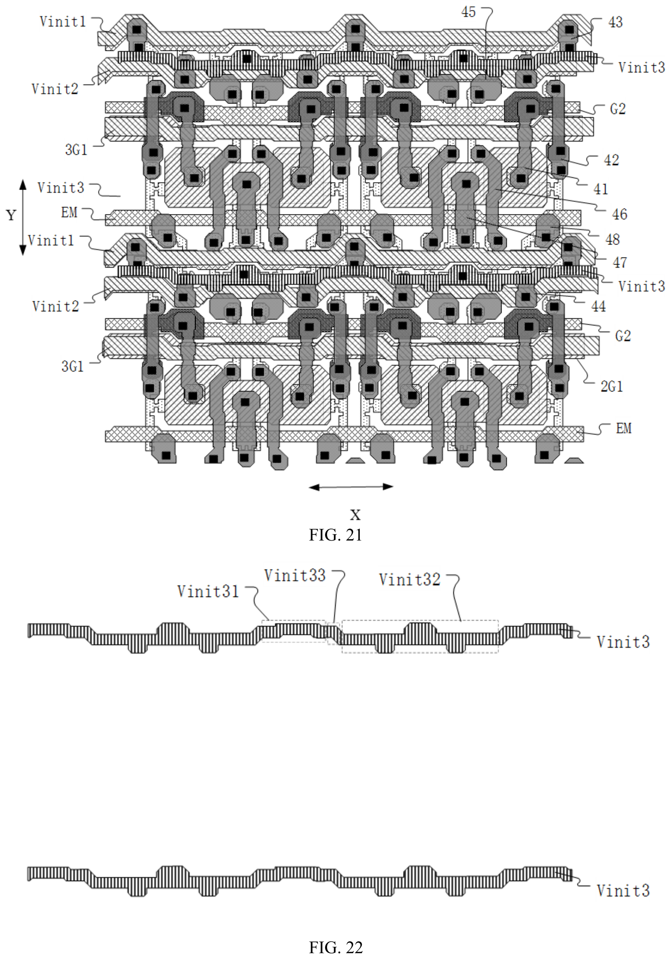

As shown in FIGS. 21 and 22, FIG. 21 is a schematic structural view of another exemplary embodiment of the display panel according to this disclosure, and FIG. 22 is a structural layout of the conductive layer provided with the third initial signal line in the display panel shown in FIG. 21. As shown in FIG. 21, it is a schematic structural view of another exemplary embodiment of the display panel according to this disclosure. The display panel shown in FIG. 21 mainly differs from the display panel shown in FIG. 3 in the third initial signal line Vinit3. As shown in FIG. 21, in the same pixel drive circuit, the orthographic projection of the first conductive part 11 on the base substrate is located between the orthographic projection of the first reset signal line Re1 on the base substrate and the orthographic projection of the second reset signal line Re2 on the base substrate. The orthographic projection of the third initial signal line Vinit3 on the base substrate is at least partially located between the orthographic projection of the second reset signal line Re2 on the base substrate in the same row of the pixel drive circuits and the orthographic projection of the first reset signal line Re1 on the base substrate in the adjacent lower row of the pixel drive circuits. This arrangement may also reduce the parasitic capacitance between the third initial signal line Vinit3 and the enable signal line EM, thereby improving the display performance of the display panel.

The display panel shown in FIG. 21 differs from the display panel shown in FIG. 3 in that a seventh conductive layer is provided on a side of the sixth conductive layer facing away from the base substrate. The third initial signal line Vinit3 may be located in the seventh conductive layer, and the sheet resistance of the seventh conductive layer may be lower than that of the first conductive layer. It should be understood that, in other exemplary embodiments, the third initial signal line Vinit3 may also be located in other conductive layers.

In this exemplary embodiment, the display panel shown in FIG. 21 may be directly formed by adding the seventh conductive layer to the display panel shown in FIG. 3. It should be noted that, due to the blocking of the second fan-out line FIPV, the third initial signal line Vinit3 may not be connected to the twelfth active part 712 through a via hole. In this exemplary embodiment, the second fan-out line FIPV may be routed or jumped to avoid the via hole for connection of the third initial signal line Vinit3. In addition, other structures of the display panel shown in FIG. 21 may be the same as those of the display panel shown in FIG. 3.

It should be noted that proportions of the drawings in this disclosure may be used as a reference in actual processes, but not limited thereto. For example, a width-to-length ratio of a channel, thickness and spacing of each film layer, and width and spacing of each signal line may be adjusted according to actual needs. The number of pixels and the number of sub-pixels in each of the pixels in a display substrate are not limited to the numbers shown in the drawings. The drawings in this disclosure are only schematic structural views. In addition, terms such as "first" and "second" are merely used to distinguish different structures and do not have specific sequences. The same structural layer may be formed through the same patterning process. In this exemplary embodiment, an orthographic projection of a certain structure on the base substrate extending in a certain direction may be understood as an orthographic projection of a structure on the base substrate extending linearly or bending along the direction.

Exemplary embodiments of the present disclosure also provide a display apparatus including the above display panel. The display apparatus may be a mobile phone, a tablet computer, a television, or other display apparatus.

Other embodiments of this disclosure will be easily conceivable to those skilled in the art from consideration of the specification and practice of the invention disclosed here. This application is intended to cover any variations, uses, or adaptations of this disclosure following the general principles thereof and including common knowledge or conventional technical means in the art that is not disclosed herein. The specification and embodiments are considered to be merely exemplary, and the true scope and spirit of this disclosure is indicated by the appended claims.

Other embodiments of this disclosure will be easily conceivable to those skilled in the art from consideration of the specification and practice of the invention disclosed here. This application is intended to cover any variations, uses, or adaptations of this disclosure following the general principles thereof and including common knowledge or conventional technical means in the art that is not disclosed herein. The specification and embodiments are considered to be merely exemplary, and the true scope and spirit of this disclosure is indicated by the appended claims.

It should be understood that this disclosure is not limited to the precise structures that have been described above and illustrated in the accompanying drawings, and various modifications and changes may be made without departing from the scope thereof. The scope of this disclosure is merely limited by the appended claims.

**Claims**

1. A display panel, comprising a pixel drive circuit, the pixel drive circuit comprising a drive transistor, a fifth transistor, and an eighth transistor, a first electrode of the fifth transistor being connected to a first power line, a second electrode of the fifth transistor being connected to a first electrode of the drive transistor, and a second electrode of the eighth transistor being connected to the first electrode of the drive transistor; the display panel comprising:

   a base substrate;
   an enable signal line on a side of the base substrate, the enable signal line being connected to a gate electrode of the fifth transistor, and an orthographic projection of the enable signal line on the base substrate extending along a first direction; and
   a third initial signal line on the side of the base substrate, the third initial signal line being connected to a first electrode of the eighth transistor, the third initial signal line comprising a first extension part, a second extension part, and a third extension part, the third extension part being connected between the first extension part and the second extension part,
   wherein an orthographic projection of the first extension part on the base substrate and an orthographic projection of the second extension part on the base substrate extend along the first direction and are staggered in a second direction, the first direction intersecting with the second direction;
   the orthographic projection of the first extension part on the base substrate does not intersect with the orthographic projection of the enable signal line on the base substrate, and the orthographic projection of the second extension part on the base substrate does not intersect with the orthographic projection of the enable signal line on the base substrate.

2. The display panel according to claim 1, wherein the display panel further comprises:

   a first active layer on the side of the base substrate, the first active layer comprising a fifth active part, the fifth active part being configured to form a channel region of the fifth transistor; and
   a first conductive layer on a side of the first active layer away from the base substrate, the first conductive layer comprising the enable signal line, the orthographic projection of the enable signal line on the base substrate covering an orthographic projection of the fifth active part on the base substrate, and a partial structure of the enable signal line being configured to form the gate electrode of the fifth transistor.

3. The display panel according to claim 1, wherein an orthographic projection of the third extension part on the base substrate intersects with the orthographic projection of the enable signal line on the base substrate.

4. The display panel according to claim 3, wherein the pixel drive circuit further comprises a second transistor, a first electrode of the second transistor being connected to a gate electrode of the drive transistor, and a second electrode of the second transistor being connected to a second electrode of the drive transistor;

   the display panel further comprises a fourth conductive layer on the side of the base substrate, the fourth conductive layer comprising a first bridge part, the first bridge part being connected to the gate electrode of the drive transistor and the first electrode of the second transistor through via holes;
   in the same pixel drive circuit, the orthographic projection of the first extension part on the base substrate is between the orthographic projection of the enable signal line on the base substrate and an orthographic projection of the first bridge part on the base substrate.

5. The display panel according to claim 3, wherein the display panel further comprises:

a first active layer comprising an eighth active part, the eighth active part being configured to form a channel region of the eighth transistor; and
a first conductive layer comprising a second reset signal line, an orthographic projection of the second reset signal line on the base substrate extending along the first direction and covering an orthographic projection of the eighth active part on the base substrate, and a partial structure of the second reset signal line being configured to form a gate electrode of the eighth transistor,
wherein in the same pixel drive circuit, at least a part of the orthographic projection of the second extension part on the base substrate is on a side of the orthographic projection of the second reset signal line on the base substrate away from the orthographic projection of the enable signal line on the base substrate.

6. The display panel according to claim 3, wherein the display panel further comprises a light-emitting unit, the pixel drive circuit is configured to drive the light-emitting unit to emit light, the pixel drive circuit further comprises a sixth transistor, a first electrode of the sixth transistor is connected to a second electrode of the drive transistor, and a second electrode of the sixth transistor is connected to a first electrode of the light-emitting unit;

the display panel further comprises a first active layer comprising a sixth active part and an eighth active part, the sixth active part being configured to form a channel region of the sixth transistor, and the eighth active part being configured to form a channel region of the eighth transistor;
in the same pixel drive circuit, in the first direction, at least a part of the orthographic projection of the third extension part on the base substrate is between an orthographic projection of the sixth active part on the base substrate and an orthographic projection of the eighth active part on the base substrate.

7. The display panel according to claim 3, wherein an orthographic projection of the first power line on the base substrate and the orthographic projection of the third extension part on the base substrate extend along the second direction, and the orthographic projection of the first power line on the base substrate does not overlap with the orthographic projection of the third extension part on the base substrate.

8. The display panel according to claim 1, wherein the display panel further comprises:

a first active layer comprising a third active part, the third active part being configured to form a channel region of the drive transistor; and
a first conductive layer comprising a first conductive part, an orthographic projection of the first conductive part on the base substrate covering an orthographic projection of the third active part on the base substrate, and the first conductive part being configured to form a gate electrode of the drive transistor,
wherein in the same pixel drive circuit, an orthographic projection of the third initial signal line on the base substrate is on a side of the orthographic projection of the enable signal line on the base substrate away from the orthographic projection of the first conductive part on the base substrate.

9. The display panel according to claim 8, wherein the first active layer further comprises an eighth active part configured to form a channel region of the eighth transistor;

the first conductive layer further comprises a second reset signal line, an orthographic projection of the second reset signal line on the base substrate extending along the first direction and covering an orthographic projection of the eighth active part on the base substrate, and a partial structure of the second reset signal line being configured to form a gate electrode of the eighth transistor;
the orthographic projection of the first extension part on the base substrate at least partially overlaps with the orthographic projection of the second reset signal line on the base substrate in a same row of the pixel drive circuit.

10. The display panel according to claim 8, wherein the display panel further comprises a light-emitting unit, and the pixel drive circuit is configured to drive the light-emitting unit to emit light;

the pixel drive circuit further comprises a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit;
the display panel further comprises:

a first active layer on the side of the base substrate, the first active layer comprising a first active part, a third active part, and a seventh active part, the first active part being configured to form a channel region of the first transistor, the third active part being configured to form a channel region of the drive transistor, and the seventh active part being configured to form a channel region of the seventh transistor; and
a first conductive layer on a side of the first active layer away from the base substrate, the first conductive layer comprising a first reset signal line, a second reset signal line, and a first conductive part, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor, an orthographic projection of the first conductive part on the base substrate covering an orthographic projection of the third active part on the base substrate, and the first conductive part being configured to form a gate electrode of the drive transistor;
the orthographic projection of the second extension part on the base substrate is between the orthographic projection of the first reset signal line on the base substrate in an adjacent next row of the pixel drive circuit and the orthographic projection of the second reset signal line on the base substrate in a same row of the pixel drive circuit.

11. The display panel according to any one of claims 1-10, wherein the pixel drive circuit further comprises a second transistor, a first electrode of the second transistor being connected to a gate electrode of the drive transistor;

the display panel further comprises a fourth conductive layer on the side of the base substrate, the fourth conductive layer comprising a first bridge part, the first bridge part being connected to the gate electrode of the drive transistor and the first electrode of the second transistor through via holes,
wherein the fourth conductive layer further comprises the third initial signal line.

12. The display panel according to claim 1, wherein the display panel further comprises a light-emitting unit, and the pixel drive circuit is configured to drive the light-emitting unit to emit light;

the pixel drive circuit further comprises a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit;
the display panel further comprises:

a first active layer on the side of the base substrate, the first active layer comprising a first active part, a third active part, and a seventh active part, the first active part being configured to form a channel region of the first transistor, the third active part being configured to form a channel region of the drive transistor, and the seventh active part being configured to form a channel region of the seventh transistor; and
a first conductive layer on a side of the first active layer away from the base substrate, the first conductive layer comprising a first reset signal line, a second reset signal line, and a first conductive part, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor, an orthographic projection of the first conductive part on the base substrate covering an orthographic projection of the third active part on the base substrate, and the first conductive part being configured to form a gate electrode of the drive transistor;

in the same pixel drive circuit, the orthographic projection of the first conductive part on the base substrate is between the orthographic projection of the first reset signal line on the base substrate and the orthographic projection of the second reset signal line on the base substrate;

an orthographic projection of the third initial signal line on the base substrate is at least partially located between the orthographic projection of the second reset signal line on the base substrate in a same row of the pixel drive circuit and the orthographic projection of the first reset signal line on the base substrate in an adjacent next row of the pixel drive circuit.

13. The display panel according to claim 12, wherein the display panel further comprises:

a fifth conductive layer on a side of the first conductive layer away from the base substrate, the fifth conductive layer comprising a ninth bridge part, and the ninth bridge part being connected to the first electrode of the fifth transistor through a via hole;

a sixth conductive layer on a side of the fifth conductive layer away from the fifth conductive layer, the sixth conductive layer comprising the first power line, and the first power line being connected to the ninth bridge part through a via hole; and

a seventh conductive layer on a side of the sixth conductive layer away from the base substrate, the seventh conductive layer comprising the third initial signal line.

14. The display panel according to claim 13, wherein the fifth conductive layer comprises a plurality of ninth bridge parts and a plurality of first connection parts, the plurality of ninth bridge parts being distributed in the first direction and the second direction, and the first connection parts being connected between two adjacent ninth bridge parts in the first direction;

the sixth conductive layer comprises a plurality of first power lines, orthographic projections of the plurality of first power lines on the base substrate extending along the second direction and being spaced apart along the first direction; each first power line is connected to the ninth bridge part intersecting with an orthographic projection of the first power line on the base substrate through a via hole.

15. The display panel according to claim 1, wherein a conductive layer provided with the third initial signal line is located on a side, away from the base substrate, of another conductive layer provided with the enable signal line; and a sheet resistance of the conductive layer provided with the third initial signal line is less than a sheet resistance of the another conductive layer provided with the enable signal line.

16. The display panel according to claim 1, wherein the display panel further comprises a plurality of repeating units distributed along the first direction and the second direction, the repeating units comprising a first pixel drive circuit and a second pixel drive circuit distributed in the first direction, and the first pixel drive circuit and the second pixel drive circuit are at least partially structurally arranged in a mirror-symmetrical manner.

17. The display panel according to claim 1, wherein the first extension part comprises a first sub-extension part and a second sub-extension part, a size of an orthographic projection of the first sub-extension part on the base substrate in the second direction is less than a size of an orthographic projection of the second sub-extension part on the base substrate in the second direction;

an orthographic projection of the first power line on the base substrate extends along the second direction and at least partially overlaps with the orthographic projection of the first sub-extension part on the base substrate.

18. The display panel according to claim 1, wherein the display panel further comprises a light-emitting unit, and the pixel drive circuit is configured to drive the light-emitting unit to emit light;

the pixel drive circuit further comprises a first transistor and a seventh transistor; a first electrode of the first transistor is connected to a first initial signal line, and a second electrode of the first transistor is connected to a second electrode of the drive transistor; a first electrode of the seventh transistor is connected to a second initial signal line, and a second electrode of the seventh transistor is connected to a first electrode of the light-emitting unit;

the display panel further comprises:

a first active layer on the side of the base substrate, the first active layer comprising a first active part and a seventh active part, the first active part being configured to form a channel region of the first transistor, and the seventh active part being configured to form a channel region of the seventh transistor; and

a first conductive layer on a side of the first active layer away from the base substrate, the first conductive layer comprising a first reset signal line and a second reset signal line, an orthographic projection of the first reset signal line on the base substrate extending along the first direction and covering an orthographic projection of the first active part on the base substrate, a partial structure of the first reset signal line being configured to form a gate electrode of the first transistor, an orthographic projection of the second reset signal line on the base substrate extending along the first direction and covering an orthographic projection of the seventh active part on the base substrate, a partial structure of the second reset signal line being configured to form a gate electrode of the seventh transistor;

an orthographic projection of the first initial signal line on the base substrate at least partially overlaps with the orthographic projection of the second reset signal line on the base substrate in an adjacent previous row of the pixel drive circuit;

an orthographic projection of the second initial signal line on the base substrate at least partially overlaps with the orthographic projection of the first reset signal line on the base substrate in the adjacent previous row of the pixel drive circuit.

19. The display panel according to claim 1, wherein the pixel drive circuit further comprises a second transistor, a first electrode of the second transistor being connected to a gate electrode of the drive transistor, and a second electrode of the second transistor being connected to a second electrode of the drive transistor;

the display panel further comprises:

a first active layer on the side of the base substrate;
a first conductive layer on a side of the first active layer away from the base substrate;
a second active layer on a side of the first conductive layer away from the first active layer, the second active layer comprising a second active part, and the second active part being configured to form a channel region of the second transistor;
a third conductive layer on a side of the second active layer away from the base substrate, the third conductive layer comprising a first gate line, an orthographic projection of the first gate line on the base substrate extending along the first direction and covering an orthographic projection of the second active part on the base substrate, and a partial structure of the first gate line being configured to form a gate electrode of the second transistor;
a fourth conductive layer on a side of the third conductive layer away from the base substrate; and
a fifth conductive layer on a side of the fourth conductive layer away from the base substrate.

20. The display panel according to claim 1, wherein the display panel further comprises a light-emitting unit, and the pixel drive circuit is configured to drive the light-emitting unit to emit light;

the pixel drive circuit further comprises:

a first transistor having a first electrode connected to a first initial signal line and a second electrode connected to a second electrode of the drive transistor;
a second transistor having a first electrode connected to a gate electrode of the drive transistor and a second electrode connected to the second electrode of the drive transistor;
a fourth transistor having a first electrode connected to a data line and a second electrode connected to the first electrode of the drive transistor;
a sixth transistor having a first electrode connected to the second electrode of the drive transistor and a second electrode connected to a first electrode of the light-emitting unit;
a seventh transistor having a first electrode connected to a second initial signal line and a second electrode connected to the first electrode of the light-emitting unit; and
a capacitor having a first electrode connected to the gate electrode of the drive transistor and a second electrode connected to the first power line,
wherein the first transistor, the drive transistor, the fourth transistor, the fifth transistor, the sixth transistor, the seventh transistor, and the eighth transistor are P-type transistors, and the second transistor is an N-type transistor.

21. The display panel according to claim 1, wherein the enable signal line outputs a plurality of pulse signals during a drive cycle of the pixel drive circuit.

22. A display apparatus, comprising the display panel according to any one of claims 1-21.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

## INTERNATIONAL SEARCH REPORT

| International application No. |
| --- |
| **PCT/CN2023/128575** |

| A. | CLASSIFICATION OF SUBJECT MATTER |
| --- | --- |

H10K59/12(2023.01)i; H01L27/12(2006.01)i; G09G3/20(2006.01)i

According to International Patent Classification (IPC) or to both national classification and IPC

| B. | FIELDS SEARCHED |
| --- | --- |

Minimum documentation searched (classification system followed by classification symbols)

IPC:H10K59 H01L27 G09G3

Documentation searched other than minimum documentation to the extent that such documents are included in the fields searched

Electronic data base consulted during the international search (name of data base and, where practicable, search terms used)

CNTXT, ENTXTC, ENTXT, VEN, CJFD, CNKI: 像素, 象素, 画素, 电路, 使能, 发光控制, 复位, 置位, 初始, 耦合电容, 寄生电容, 投影, 横纹, 分屏不良, 显示质量, 分段, 第三部, 延伸, 弯曲, 曲线, enabl+, emit control+, initial+, reset+, coupl+, project+, bend+, curv+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 115398640 A (BOE TECHNOLOGY GROUP CO., LTD. et al.) 25 November 2022 (2022-11-25)<br>  description, paragraphs 117-529, and figures 7-54 | 1-2, 8-9, 16, 19, 22 |
| Y | CN 115398640 A (BOE TECHNOLOGY GROUP CO., LTD. et al.) 25 November 2022 (2022-11-25)<br>  description, paragraphs 117-529, and figures 7-54 | 20-21 |
| Y | CN 116568078 A (BOE TECHNOLOGY GROUP CO., LTD. et al.) 08 August 2023 (2023-08-08)<br>  description, paragraphs 113-256, and figures 2-19B | 20-21 |
| A | CN 116437750 A (SAMSUNG DISPLAY CO., LTD.) 14 July 2023 (2023-07-14)<br>  entire document | 1-22 |
| A | CN 115241255 A (BOE TECHNOLOGY GROUP CO., LTD. et al.) 25 October 2022 (2022-10-25)<br>  entire document | 1-22 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **04 June 2024** | **18 July 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**EP 4 646 078 A1**

**INTERNATIONAL SEARCH REPORT**

International application No.

**PCT/CN2023/128575**

**C.    DOCUMENTS CONSIDERED TO BE RELEVANT**

| Category* | Citation of document, with indication, where appropriate, of the relevant passages | Relevant to claim No. |
|---|---|---|
| A | CN 111477669 A (BOE TECHNOLOGY GROUP CO., LTD.) 31 July 2020 (2020-07-31)<br>entire document | 1-22 |
| A | WO 2023109232 A1 (BOE TECHNOLOGY GROUP CO., LTD. et al.) 22 June 2023<br>(2023-06-22)<br>entire document | 1-22 |
| A | WO 2023044682 A1 (BOE TECHNOLOGY GROUP CO., LTD. et al.) 30 March 2023<br>(2023-03-30)<br>entire document | 1-22 |

Form PCT/ISA/210 (second sheet) (July 2022)

34

**INTERNATIONAL SEARCH REPORT**
**Information on patent family members**

International application No.

**PCT/CN2023/128575**

| Patent document cited in search report | | | Publication date (day/month/year) | Patent family member(s) | | | Publication date (day/month/year) |
|---|---|---|---|---|---|---|---|
| CN | 115398640 | A | 25 November 2022 | WO | 2023044678 | A1 | 30 March 2023 |
| | | | | CN | 115398640 | B | 26 May 2023 |
| CN | 116568078 | A | 08 August 2023 | CN | 220342749 | U | 12 January 2024 |
| CN | 116437750 | A | 14 July 2023 | KR | 20230109211 | A | 20 July 2023 |
| | | | | US | 2023225160 | A1 | 13 July 2023 |
| | | | | EP | 4224528 | A2 | 09 August 2023 |
| | | | | EP | 4224528 | A3 | 29 November 2023 |
| CN | 115241255 | A | 25 October 2022 | WO | 2024022240 | A1 | 01 February 2024 |
| | | | | WO | 2024022240 | A9 | 28 March 2024 |
| CN | 111477669 | A | 31 July 2020 | US | 2023180552 | A1 | 08 June 2023 |
| | | | | JP | 2023525087 | A | 14 June 2023 |
| | | | | US | 2022336566 | A1 | 20 October 2022 |
| | | | | US | 11950468 | B2 | 02 April 2024 |
| | | | | EP | 4135044 | A1 | 15 February 2023 |
| | | | | EP | 4135044 | A4 | 11 October 2023 |
| | | | | WO | 2021227553 | A1 | 18 November 2021 |
| | | | | WO | 2021227760 | A1 | 18 November 2021 |
| | | | | CN | 114175265 | A | 11 March 2022 |
| | | | | CN | 111477669 | B | 18 April 2022 |
| WO | 2023109232 | A1 | 22 June 2023 | GB | 202401557 | D0 | 20 March 2024 |
| | | | | GB | 2624331 | A | 15 May 2024 |
| | | | | CN | 216818344 | U | 24 June 2022 |
| | | | | CN | 116267004 | A | 20 June 2023 |
| WO | 2023044682 | A1 | 30 March 2023 | WO | 2023044682 | A9 | 28 September 2023 |
| | | | | CN | 116157857 | A | 23 May 2023 |

Form PCT/ISA/210 (patent family annex) (July 2022)